(19) Europäisches Patentamt / European Patent Office / Office européen des brevets

(11) **EP 3 982 169 A1**

(12) **EUROPEAN PATENT APPLICATION**
published in accordance with Art. 153(4) EPC

(43) Date of publication:
**13.04.2022 Bulletin 2022/15**

(21) Application number: **19931791.8**

(22) Date of filing: **31.12.2019**

(51) International Patent Classification (IPC):
*G02B 5/20* (2006.01)    *G02B 5/28* (2006.01)

(86) International application number:
**PCT/CN2019/130575**

(87) International publication number:
**WO 2020/244221 (10.12.2020 Gazette 2020/50)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **05.06.2019 CN 201910486854**

(71) Applicant: **Xin Yang Sunny Optics Co., Ltd.**
**Xinyang, Henan 464006 (CN)**

(72) Inventors:
• **CHEN, Ce**
**Xinyang, Henan 464006 (CN)**

• DING, Weihong
Xinyang, Henan 464006 (CN)
• CHEN, Huiguang
Xinyang, Henan 464006 (CN)
• FANG, Yeqing
Xinyang, Henan 464006 (CN)
• XIAO, Niangong
Xinyang, Henan 464006 (CN)

(74) Representative: **Müller-Boré & Partner**
**Patentanwälte PartG mbB**
**Friedenheimer Brücke 21**
**80639 München (DE)**

(54) **NEAR-INFRARED BANDPASS FILTER AND OPTICAL SENSING SYSTEM**

(57) The disclosure provides a near-infrared bandpass filter (5) and an optical sensing system. The near-infrared bandpass filter (5) includes a substrate (51), a set of main films (52) located on a first side of the substrate and a set of secondary films (53) located on a second side of the substrate, wherein the second side is opposite to the first side. The set of main films (52) includes a high refractive index film layer and a first low refractive index film layer arranged in a first preset stacked structure. The set of secondary films (53) includes a second low refractive index film layer and a third low refractive index film layer, or the high refractive index film layer and the second low refractive index film layer, arranged in a second preset stacked structure. In a wavelength range of 780nm to 3000nm, the near-infrared bandpass filter (5) has at least one passband, and when a temperature is changed from -150 °C to 300 °C, a drift amount of a center wavelength of the at least one passband is less than 0.15 nm/°C. The near-infrared bandpass filter provided in the present disclosure can be used to filter light in an operating environment with temperature changes, and the filtered light is stable, so as to improve the imaging quality of the optical sensor system.

Fig. 1

**Description**

CROSS-REFERENCE TO RELATED APPLICATION

This application claims priority to Chinese Patent Application, with the Application No. 201910486854.8 and the title "Near-Infrared Bandpass Filter and Optical Sensing System", filed before the China National Intellectual Property Administration (CNIPA) on June 5, 2019, the disclosure of which is hereby incorporated by reference in its entirety.

TECHNICAL FIELD

The present disclosure relates to the field of optical filters, and more particularly, to a near-infrared bandpass filter and an optical sensing system.

BACKGROUND

An infrared sensing system receives an infrared ray reflected by a target to form an image, and then processes the image to obtain information of the target. The infrared sensing system is generally applied in the fields of face recognition, gesture recognition, intelligent home, and the like. The infrared sensing system includes components such as a lens, an optical filter, and an image sensor.

The effect of temperature on the performance of an infrared sensing system is referred to as temperature stability. Devices, such as on-vehicle lidars, space probes, or optical communication devices, often operate at extreme temperatures. The temperature at which these devices are actually used differs greatly from the temperature at which they are manufactured and debugged, and thus the temperature stability of the infrared sensing system on these devices is required to be high. In order to ensure the temperature stability of the devices, the prior art generally improves the structure, material and the like of the lens to ensure the imaging quality of the infrared sensor system, or focuses on the thermal drift of the electrical properties of the image sensor to ensure the quality of the image data of the infrared sensing system.

However, there is still a need for optical filters in which optical properties are less affected by temperature variations, such as, optical filters in which the central wavelength offset of the passband is less affected by temperature variations. The passband variation of the optical filters also affects the imaging quality of the infrared sensing system, and the prior art generally focuses only on the influence of the incident angle of the light on the central wavelength offset of the passband. Therefore, it is desirable to provide an optical filter in which the central wavelength offset of the passband is less affected by the temperature variation.

SUMMARY

To address or partially address the above drawbacks of the prior art, the present disclosure provides a near-infrared bandpass filter and an optical sensing system.

In a first aspect, an example of the present disclosure provide a near-infrared bandpass filter including a substrate, a set of main films located on a first side of the substrate and a set of secondary films located on a second side of the substrate, wherein the second side is opposite to the first side. The set of main films includes a high refractive index film layer and a first low refractive index film layer arranged in a first preset stacked structure. The set of secondary films includes a second low refractive index film layer and a third low refractive index film layer arranged in a second preset stacked structure, and a refractive index of the third low refractive index film layer is different from a refractive index of the second low refractive index film layer. Alternatively, the set of secondary films includes the high refractive index film layer and the second low refractive index film layer arranged in a second preset stacked structure. In a wavelength range of 780nm to 3000nm, the near-infrared bandpass filter has at least one passband, and when a temperature is changed from -150 °C to 300 °C, a drift amount of a center wavelength of the at least one passband is less than 0.15 nm/°C.

In one embodiment, when the temperature is changed from -30 °C to 85 °C, the drift amount of the center wavelength of the passband of the near-infrared bandpass filter is less than 0.09 nm/°C.

In one embodiment, the high refractive index film layer has a refractive index of more than 3 for any wavelength in the wavelength range of 780 nm to 3000 nm.

In one embodiment, an extinction coefficient of the high refractive index film layer is less than 0.01.

In one embodiment, the high refractive index film layer has the refractive index of more than 3.6 and the extinction coefficient of less than 0.005 at a wavelength of 850 nm.

In one embodiment, a thickness $d_{f1}$ of the set of main films satisfies $d_{f1} < 7\mu m$, and a thickness $d_{f2}$ of the set of secondary films satisfies $d_{f2} < 8\mu m$.

In one embodiment, a portion of the high refractive index film layer has a crystalline crystal structure and another portion has an amorphous crystal structure. A ratio between a volume of the portion in the crystalline crystal structure and a volume of the high refractive index film layer is within 10% to 20%.

In one embodiment, a material of the high refractive index film layer comprises a mixture of one or more of silicon hydride, germanium hydride, boron-doped silicon hydride, boron-doped germanium hydride, nitrogen-doped silicon hydride, nitrogen-doped germanium hydride, phosphorous-doped silicon hydride, phosphorous-doped germanium hydride, or $Si_xGe_{1-x}$, where $0<x<1$.

In one embodiment, a material of the first low refractive index film layer, a material of the second low refractive index film layer and a material of the third low refractive index film layer each comprises a mixture of one or more of $SiO_2$, $Si_3N_4$, $SiO_pN_q$, $Ta_2O_5$, $Nb_2O_5$, $TiO_2$, $Al_2O_3$, SiCN, or SiC, where $q=(4-2p)/3$, and $0<p<1$.

In one embodiment, a material of the substrate includes glass.

In one embodiment, in a direction away from the substrate, the first preset stacked structure is in a form of $(L_1-H)^s-L_1$, or $(H-L_1)^s$, where H represents the high refractive index film layer, $L_1$ represents the first low refractive index film layer, s represents a number of repetitions of a structure in parentheses, and s is an integer equal to or greater than 1.

In one embodiment, the set of main films further includes a fourth low refractive index film layer, and a refractive index of the first low refractive index film layer is not equal to a refractive index of the fourth low refractive index film layer.

In one embodiment, in a direction away from the substrate, the first preset stacked structure is in a form of: $(L_1-L_4-L_1-H)^s-L_1$; $(L_1-L_4-L_1-H)^s-L_4$; $H-(L_1-L_4-L_1-H)^s-L_1$; or $H-(L_1-L_4-L_1-H)^s-L_4$, where H represents the high refractive index film layer, L1 represents the first low refractive index film layer, L4 represents the fourth low refractive index film layer, s represents a number of repetitions of a structure in parentheses, and *s* is an integer greater than or equal to 1.

In one embodiment, the set of main films is a set of narrow bandpass films, and the set of secondary films is a set of wide bandpass films or a set of longwave pass films.

In one embodiment, the set of narrow bandpass films has at least one passband in the wavelength range of 780nm to 3000nm.

In one embodiment, the set of secondary films is the set of longwave pass films; and the set of longwave pass films has at least one passband and one cut-off band in a wavelength range of 350 nm to 3000nm, and the passband of the set of longwave pass films covers the passband of the set of narrow bandpass films.

In one embodiment, the set of secondary films is the set of wide bandpass films, and a passband of the set of wide bandpass films covers the passband of the set of narrow bandpass films; and an average blocking of the set of wide bandpass films is greater than a blocking of the set of narrow bandpass films in a wavelength region less than a minimum wavelength of the passband of the set of narrow bandpass films.

In one embodiment, a material of the substrate has a linear expansion coefficient between $3*10^{-6}/°C$ and $17*10^{-6}/°C$.

In one embodiment, the set of main films and the set of secondary films are formed by a sputtering reaction apparatus or an evaporation apparatus.

In a second aspect, an example of the present disclosure further provides an optical sensing system including an image sensor and the near-infrared bandpass filter as described above. The near-infrared bandpass filter is disposed on a photosensitive side of the image sensor.

In the near-infrared bandpass filter provided in the present disclosure, a set of main films and a set of secondary films are provided on both sides of a substrate, respectively. The refractive index of the film layer of the set of secondary films is smaller than or equal to the refractive index of the high refractive index film layer of the set of main films, so that the equivalent refractive index of the set of secondary films is not greater than the equivalent refractive index of the set of main films. Meanwhile, the structure of the near-infrared bandpass filter is provided such that the set of main films includes film layers arranged in a first stacked structure to fit the substrate, and the set of secondary films includes film layers arranged in a second stacked structure, so that the drift amount of the center wavelength of the passband of the set of secondary films is not greater than the drift amount of the center wavelength of the passband of the set of main films. Then, when the temperature is changed from -150 °C to 300 °C, the temperature drift of the center wavelength of the passband of the near-infrared band pass filter is less than 0.15 nm/°C in the wavelength range of 780nm to 3000nm. In this way, it is ensured that some light rays in the near-infrared wavelength range can penetrate the near-infrared bandpass filter provided in the present disclosure, and the difference between the transmitted light at different temperatures is small. The optical sensing system provided with the near-infrared bandpass filter provided in the present disclosure has little influence on the imaging quality when operating in an environment in which the temperature changes.

BRIEF DESCRIPTION OF THE DRAWINGS

Other features, objects, and advantages of the present disclosure will become more apparent by reading the detailed description of the non-limiting examples with reference to the accompanying drawings:

FIG. 1 shows a schematic structural diagram of a near-infrared bandpass filter according to an example of the present disclosure;

FIG. 2 shows a schematic diagram of an operating state of an optical sensing system according to an example of the present disclosure;

FIG. 3 shows a transmittance curve of a set of bandpass films of Table 1 according to an example of the present disclosure;

FIG. 4 shows a transmittance curve of a set of bandpass films of Table 2 according to an example of the present disclosure;

FIG. 5 shows a transmittance curve of a set of long wave-pass films of Table 3 according to an example of the present disclosure;

FIG. 6 shows a transmittance curve of a set of long wave-pass films of Table 4 according to an example of the present disclosure;

FIG. 7 shows transmittance curves of a near-infrared bandpass filter according to an example of the present disclosure corresponding to incident light at different angles;

FIG. 8 shows transmittance curves of the near-infrared bandpass filter according to FIG. 7 at different temperatures;

FIG. 9 shows transmittance curves of a near-infrared bandpass filter according to another example of the present disclosure corresponding to incident light at different angles;

FIG. 10 shows transmittance curves of the near-infrared bandpass filter according to FIG. 9 at different temperatures;

FIG. 11 shows transmittance curves of a near-infrared bandpass filter according to another example of the present disclosure at different temperatures;

FIG. 12 shows transmittance curves of a near-infrared bandpass filter according to still another example of the present disclosure corresponding to incident light at different angles;

FIG. 13 shows transmittance curves of the near-infrared bandpass filter according to FIG. 12 at different temperatures;

FIG. 14 shows transmittance curves of a near-infrared bandpass filter according to still another example of the present disclosure corresponding to incident light at different angles; and

FIG. 15 shows transmittance curves of the near-infrared bandpass filter according to Fig. 14 at different temperatures.

## DETAILED DESCRIPTION OF EMBODIMENTS

For a better understanding of the present disclosure, various aspects of the present disclosure will be described in more detail with reference to the accompanying drawings. It should be understood that the detailed description is merely illustrative of the exemplary embodiments of the present disclosure and is not intended to limit the scope of the present disclosure in any way. Throughout the specification, the same reference numerals refer to the same elements. The expression "and/or" includes any and all combinations of one or more of the associated listed items.

It should be noted that in the present specification, the expressions such as first, second, third are used merely for distinguishing one feature from another, without indicating any limitation on the features. Thus, a first side discussed below may also be referred to as a second side without departing from the teachings of the present disclosure, and vice versa.

In the accompanying drawings, the thickness, size and shape of the component have been somewhat adjusted for the convenience of explanation. The accompanying drawings are merely illustrative and not strictly drawn to scale. For example, the ratio between the thickness and the length of the first set of films is not in accordance with the ratio in actual production. As used herein, the terms "approximately," "about," and similar terms are used as approximate terms, not as terms representing degree, and are intended to describe inherent deviations in the value that will be recognized, measured or calculated by those of ordinary skill in the art.

As used herein, the thickness of the film layer refers to the thickness in a direction away from the substrate.

It should be further understood that the terms "comprising," "including," "having," "containing" and/or "contain," when used in the specification, specify the presence of stated features, elements and/or components, but do not exclude the presence or addition of one or more other features, elements, components and/or combinations thereof. In addition, expressions, such as "at least one of," when preceding a list of features, modify the entire list of features rather than an individual element in the list. Further, the use of "may," when describing embodiments of the present disclosure, refers to "one or more embodiments of the present disclosure." Also, the term "exemplary" is intended to refer to an example or illustration.

Unless otherwise defined, all terms (including engineering terms and scientific and technological terms) used herein have the same meaning as commonly understood by those of ordinary skill in the art to which the present disclosure belongs. It will be further understood that terms, those defined in commonly used dictionaries, should be interpreted as having a meaning that is consistent with the meaning in the context of the relevant art and will not be interpreted in an idealized or overly formal sense, unless expressly so defined herein.

It should also be noted that, the examples in the present disclosure and the features in the examples may be combined with each other on a non-conflict basis. In addition, unless clearly defined or contradictory to the context, the specific steps included in the method described in the present disclosure are not necessarily limited to the described order, and can be executed in any order or in parallel. The present disclosure will be described in detail below with reference to the accompanying drawings and in combination with the examples.

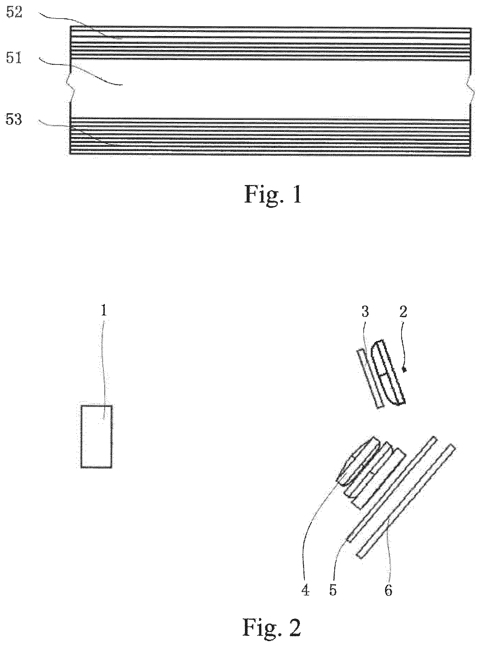

FIG. 1 shows a schematic structural diagram of a near-infrared bandpass filter according to an example of the present disclosure. Referring to FIG. 1, an example of the present disclosure provides a near-infrared bandpass filter 5 including a substrate 51, a set of main films 52 located on a first side of the substrate 51, and a set of secondary films 53 located on a second side of the substrate, wherein the first side is opposite to the second side. The substrate 51 is a transparent substrate, and the material of the transparent substrate may optionally be crystal, high borosilicate glass, or the like, and may specifically be D263T, AF32, Eagle XG, H-ZPK5, H-ZPK7, or the like. Exemplarily, the substrate 51 may be a transparent sheet. The upper and lower directions in FIG. 1 are the thickness directions of the transparent sheet, and the upper side and the lower side of the transparent sheet are opposite. The set of main films 52 is disposed on the outer side above the substrate 51, and the set of secondary films 53 is disposed on the outer side below the substrate 51.

The set of main films 52 includes a high refractive index film layer and a first low refractive index film layer arranged in a first preset stacked structure, and the refractive index $n_1$ of the high refractive index film layer is larger than the refractive index $n_{21}$ of the first low refractive index film layer when corresponding to the same wavelength. Alternatively, in a direction away from the substrate 51, the first preset stacked structure is in the form of $(L_1\text{-}H)^s\text{-}L_1$ or $(H\text{-}L_1)^s$, where H represents the high refractive index film layer, L1 represents the first low refractive index film layer, s represents a number of repetitions of the structure in parentheses, and s is an integer equal to or greater than 1. Exemplarily, when s is 5, the first preset stacking structure is in the form of $L_1HL_1HL_1HL_1HL_1HL_1$.

In an embodiment, after the set of main films 52 is provided with the film layer in the first preset stacked structure, an aggregation density $P_0$ of the film layer is satisfied $0.9 < P_0 < 1.6$.

The set of secondary films 53 includes a second low refractive index film layer and a third low refractive index film layer, or a high refractive index film layer and a second low refractive index film layer, arranged in a second preset stacked structure. When the set of secondary films 53 includes the second low refractive index film layer and the third low refractive index film layer arranged in the second preset stacked structure, the refractive index of the second low refractive index film layer is not equal to the refractive index of the third low refractive index film layer, and the refractive index of the third low refractive index film layer is smaller than the refractive index of the high refractive index film layer of the set of main films 52. The second preset stacked structure may refer to the first preset stacked structure. The second preset stacked structure may be $(L_2\text{-}L_3)^z\text{-}L_2$ or $(L_2\text{-}L_3)^z$, where L2 refers to the second low refractive index film layer, L3 refers to the third low refractive index film layer, and z is an integer greater than or equal to 1.

Since the set of main films 52 includes a high refractive index film layer and a first low refractive index film layer arranged in a first preset stacked structure, and the set of secondary films 53 includes a second low refractive index film layer and a third low refractive index film layer arranged in a second preset stacked structure, the near-infrared bandpass filter 5 disclosed in the present disclosure may be an interference filter. The refractive index of the third low refractive index film layer is not greater than the refractive index of the high refractive index film layer, so that the characteristics of the set of main films 52 have a greater effect on the characteristics of the near-infrared bandpass filter 5. Each of the film layers of the set of main films 52 may be a film layer formed by a sputtering reaction method, and each of the film layers of the set of secondary films 53 may be a film layer generated by a sputtering reaction method or an evaporation method. Such a manufacturing method integrates the substrate 51, the set of main films 52, and the set of secondary films 53.

In the wavelength range from 780nm to 3000nm, the near-infrared bandpass filter 5 disclosed in the present example has at least one passband, and when the temperature is changed from -150 °C to 300 °C, the drift amount of the center wavelength of the passband of the near-infrared bandpass filter 5 is less than 0.15 nm/°C. In an embodiment, when the temperature is changed from -150 °C to 300 °C, the drift amount of the center wavelength of the passband is less than 0.12 nm/°C. In an embodiment, the drift amount of the center wavelength of the passband is less than 0.09 nm/°C. In the embodiment, when the temperature is changed from - 30 °C to 85 °C, the drift amount of the center wavelength of the passband of the near-infrared bandpass filter is less than 0.09 nm/°C. In an embodiment, the drift amount of the center wavelength of the passband of the near-infrared bandpass filter is less than 0.05 nm/°C.

The wavelength range 780nm to 3000 nm is located in the near infrared, and a passband is formed in this wavelength range, such that the light passing through the near-infrared bandpass filter 5 includes at least a portion of the near infrared light. By matching the structure of the set of main films 52 with the substrate 51, it is satisfied that the drift amount of the center wavelength of the passband of the near-infrared bandpass filter 5 is less than 0.15 nm/°C when the temperature is changed from -150 °C to 300 °C.

The near-infrared bandpass filter 5 disclosed herein can be used at least in a temperature environment of about -150 °C and a temperature environment of about 300 °C. The center wavelength of the passband has a drift amount of less than 0.15 nm/°C in the wavelength range of 780 nm to 3000 nm. In an operating environment in which the temperature changes greatly, the light passing through the near-infrared bandpass filter 5 disclosed in the present disclosure contains near infrared light in a stable region. Signals carried by near infrared lights in the stable region are stable.

In an exemplary embodiment, the refractive index of the high refractive index film layer is greater than 3 for any wavelength in the wavelength range of 780 nm to 3000 nm. In an embodiment, the refractive index of the high refractive index film layer is greater than 3.2 for any wavelength in the range of 800 nm to 1100 nm. In an embodiment, the refractive index of the high refractive index film layer is greater than 3.5 for any wavelength in the range of 800 nm to 900 nm. In a wavelength region close to the visible light, the high refractive index film layer has a higher refractive index, so that the temperature stability of the signal carried by the infrared light in the said wavelength region can be improved. Moreover, when the refractive index of the high refractive index film layer is greater than 3.5, the influence of the structure of the set of main films 52 on the optical characteristics of the near-infrared bandpass filter 5 disclosed in the present disclosure can be further improved. Thus, a desired effect can be achieved by using a simpler form of the first preset stacked structure to stack the set of main films 52 to cooperate with the substrate 51.

In an exemplary embodiment, an extinction coefficient of the high refractive index film layer is less than 0.01.

In an exemplary embodiment, the high refractive index film layer has a refractive index greater than 3.6 and an extinction coefficient less than 0.005 corresponding to the wavelength of 850 nm. By setting the extinction coefficient, the light transmittance of the high refractive index film layer can be increased, the loss of light in the passband range of the high refractive index film layer can be reduced, the intensity of light passing through the near-infrared bandpass filter 5 can be increased, and the clarity of the signal can be improved.

In an exemplary embodiment, a portion of the material of the high refractive index film layer is in a crystalline state and another portion is in an amorphous state. The ratio between the volume of the portion where the crystal structure is crystalline and the volume of the high refractive index film layer is within 10% to 20%. When the near-infrared bandpass filter 5 disclosed in the present disclosure contains a high refractive index film layer having such a crystal structure, the temperature drift of the passband of the near-infrared bandpass filter 5 is much small. In an embodiment, the volume of the portion where the crystal structure is crystalline accounts for 15%.

In an exemplary embodiment, the material of the high refractive index film layer includes a mixture of one or more of silicon hydride, germanium hydride, boron-doped silicon hydride, boron-doped germanium hydride, nitrogen-doped silicon hydride, nitrogen-doped germanium hydride, phosphorous-doped silicon hydride, phosphorous-doped germanium hydride, or $Si_xGe_{1-x}$, where $0<x<1$. Exemplarily, $Si_xGe_{1-x}$ is $Si_{0.4}Ge_{0.6}$. Exemplarily, the mixture may be silicon germanium hydride, and the ratio of silicon to germanium may be any ratio. The mixture may be nitrogen-doped silicon germanium hydride or boron-doped phosphorous-doped germanium hydride.

In an exemplary embodiment, the material of the first low refractive index film layer, the material of the second low refractive index film layer, and the material of the third low refractive index film layer each includes a mixture of one or more of $SiO_2$, $Si_3N_4$, $SiO_pN_q$, $Ta_2O_5$, $Nb_2O_5$, $TiO_2$, $Al_2O_3$, SiCN, or SiC, where $q=(4-2p)/3$, and $0<p<1$. Exemplarily, $SiO_pN_q$ may be $SiON_{2/3}$. Exemplarily, the mixture is $TiO_2$ and $Al_2O_3$, or $Ta_2O_5$ and $Nb_2O_5$, or $SiO_2$, SiCN and SiC. Exemplarily, the material of the second low refractive index film layer includes a mixture of $SiO_2$ and $TiO_2$ formed in a 2:1 ratio, and the material of the third low refractive index film layer includes a mixture of SiO2 and TiO2 formed in a 1:3 ratio.

In an exemplary embodiment, the set of main films further includes a fourth low refractive index film layer, and the refractive index of the first low refractive index film layer is not equal to the refractive index of the fourth low refractive index film layer. The first low refractive index film layer and the fourth low refractive index film layer are respectively provided in the set of main films 52, so that the set of main films 52 can be provided in a more flexible manner and can be properly matched with the substrate 51 having different characteristics. Alternatively, the first preset stacked structure is in the form of $(L-H)^s-L$ or $(H-L)^s$, and the low refractive index film layer L may alternately be a first low refractive index film layer and a fourth low refractive index film layer.

In an exemplary embodiment, in a direction away from the substrate, the first preset stacked structure is in the form of: $(L_1-L_4-L_1-H)^s-L_1$; $(L_1-L_4-L_1-H)^s-L_4$; $H-(L_1-L_4-L_1-H)^s-L_1$; or $H-(L_1-L_4-L_1-H)^s-L_4$, where H represents a high refractive index film layer, $L_1$ represents a first low refractive index film layer, $L_4$ represents a fourth low refractive index film layer, S represents a number of repetitions of the structure in parentheses, and s is an integer equal to or greater than 1.

In an exemplary embodiment, the set of main films 52 is a set of bandpass films. In an exemplary embodiment, the set of main films 52 is a set of narrow bandpass films and the set of secondary films 53 is a set of wide bandpass films or a set of longwave pass films.

In an exemplary embodiment, the set of main films 52 and the set of secondary films 53 are formed by a sputtering reaction apparatus or an evaporation apparatus.

In an exemplary embodiment, the set of narrow bandpass films has at least one passband in a wavelength range of 700 nm to 1200 nm. The film layer of the set of narrow bandpass films may be a sputtered reactive coating layer.

In a specific embodiment, a set of main films 52 is disclosed, as shown in Table 1:

Table 1: Preset stacked structure of a set of main films (unit of thickness: nm)

| Material | SiO$_2$ | a-Si:H | SiO$_2$ | a-Si:H | SiO$_2$ | a-Si:H |
|---|---|---|---|---|---|---|
| Layer | 1 | 2 | 3 | 4 | 5 | 6 |
| Thickness | 361.25 | 88.32 | 298.72 | 189.22 | 184.49 | 191.56 |
| Layer | 7 | 8 | 9 | 10 | 11 | 12 |
| Thickness | 317.45 | 61.19 | 181.65 | 190.48 | 245.69 | 110.32 |
| Layer | 13 | 14 | 15 | 16 | 17 | 18 |
| Thickness | 217.41 | 163.25 | 69.09 | 250.43 | 44.4 | 185.23 |
| Layer | 19 | 20 | 21 | 22 | 23 | 24 |
| Thickness | 352.08 | 65.27 | 121.32 | 291.6 | 99.99 | 148.96 |
| Layer | 25 | 26 | 27 | 28 | 29 | |
| Thickness | 134.26 | 125.89 | 81.07 | 127.42 | 79.06 | |

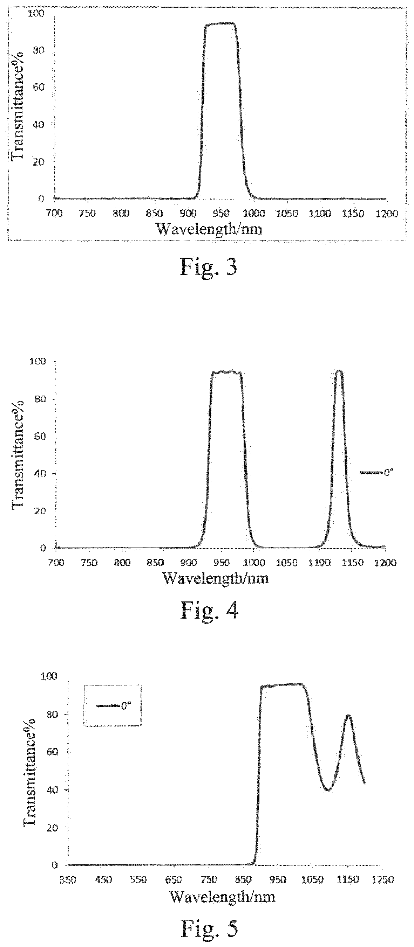

The set of main films 52 is a set of narrow bandpass films with a single passband. The layers in Table 1 refer to the layers along the stacking direction. The first layer is the film layer closest to the substrate 51, and the 29th layer is the film layer furthest away from the substrate 51. The materials of the film layers in the same column in the table are the same. Among the film layers of the set of main films 52, the odd-numbered layers are first low refractive index film layers, the even-numbered layers are high refractive index film layers, and the material of the even-numbered layer is amorphous silicon hydride, that is, a-Si:H. The transmittance curve of the set of main films 52 is shown in FIG. 3. The set of main films 52 includes a passband in a wavelength range from 700 nm to 1200 nm, and the center wavelength of the passband is about 950 nm.

A method of coating the set of main films 52 is as follows: evacuating the sputtering reaction apparatus to a vacuum level of less than $5 \times 10^{-5}$ Torr, and placing the substrate 51 and the silicon target in corresponding positions; setting a flow rate of an argon gas to 10 sccm to 80 sccm, a sputtering power greater than 3000 kw, a flow rate of an oxygen gas to 10 sccm to 80 sccm, and a processing temperature of 80 °C to 300 °C, to coat the low refractive index film layer. In an exemplary embodiment, the flow rate of the argon gas is set to 45 sccm and the flow rate of the oxygen gas is set to 45 sccm.

In addition, when the high refractive index film layer is coated, the flow rate of the argon gas is set to 10 sccm to 80 sccm, the sputtering power is greater than 3000 kw, and a flow rate of a hydrogen gas is set to 10 sccm to 80 sccm. In an exemplary embodiment, the flow rate of the hydrogen gas is set to 45 sccm.

In a specific embodiment, a set of main films 52 is disclosed, as shown in Table 2:

Table 2: Preset stacked structure of a set of main films (unit of thickness: nm)

| Material | a-Si:H | SiO$_2$ | a-Si:H | SiO$_2$ | a-Si:H | SiO$_2$ |
|---|---|---|---|---|---|---|
| Layer | 1 | 2 | 3 | 4 | 5 | 6 |
| Thickness | 63.03 | 328.03 | 316.14 | 225.56 | 308.38 | 659.75 |
| Layer | 7 | 8 | 9 | 10 | 11 | 12 |
| Thickness | 63.23 | 184.43 | 31.57 | 661.6 | 364.41 | 73.26 |
| Layer | 13 | 14 | 15 | | | |
| Thickness | 326.31 | 283.28 | 105.92 | | | |

The set of main films 52 is a set of narrow bandpass films with two passbands. The first layer is a film layer closest to the substrate 51. The set of main films 52 has a transmittance curve shown in FIG. 4. The set of main films 52 includes a passband having a center wavelength of about 960 nm and a passband having a center wavelength of about 1130 nm in a wavelength range of 700 nm to 1200 nm.

In an exemplary embodiment, the set of secondary films 53 is a set of longwave pass films. In a wavelength range of 350 nm to 1200 nm, the set of longwave pass films has at least one passband and one cut-off band, and the passband of the set of longwave pass films covers the passband of the set of narrow bandpass films.

In a specific embodiment, a set of longwave pass films is disclosed, as shown in Table 3:

Table 3: Preset stacked structure of a set of longwave pass films (unit of thickness: nm)

| Material | SiO$_2$ | Si:H | SiO$_2$ | Si:H | SiO$_2$ | Si:H |
|---|---|---|---|---|---|---|
| Layer | 1 | 2 | 3 | 4 | 5 | 6 |
| Thickness | 118.99 | 144.41 | 121.91 | 40.98 | 99.76 | 38.13 |
| Layer | 7 | 8 | 9 | 10 | 11 | 12 |
| Thickness | 108.77 | 46.76 | 96.72 | 40 | 21 | 105 |
| Layer | 13 | 14 | 15 | 16 | 17 | 18 |
| Thickness | 114.2 | 162.36 | 134.9 | 20 | 20 | 20 |
| Layer | 19 | 20 | 21 | 22 | 23 | 24 |
| Thickness | 86.73 | 41.24 | 117.94 | 60.05 | 45.65 | 53.89 |
| Layer | 25 | | | | | |
| Thickness | 139.6 | | | | | |

The transmittance curve of the set of secondary films 53 is shown FIG. 5. In the wavelength range of 350 nm to 1200 nm, the set of secondary films 53 includes a passband and a cut-off band, and the passband of the set of secondary films ranges from about 900 nm to 1000 nm. Exemplarily, a near-infrared bandpass filter includes the set of longwave pass films and the set of narrow bandpass films disclosed in Table 1, and the passband of the set of longwave pass films covers the passband of the set of narrow bandpass films. The cut-off band covers at least the band of 350 nm to 850 nm, and thus visible light can be cut off.

A method of coating the set of longwave pass films is as follows: evacuating the vacuum evaporation reaction apparatus to a vacuum level of less than $9 \times 10^{-4}$ Torr, and placing the substrate 51 and the raw material of the coating in corresponding positions; setting a flow rate of an argon gas to 10 sccm to 20 sccm, a voltage of 900 V to 1300 V, a current of 900 mA to 1300 mA, a flow rate of an oxygen gas to 30 sccm to 90 sccm, and an operating temperature of 80 °C to 300 °C, to coat each film layer. In an exemplary embodiment, the flow rate of the argon gas is set to 13sccm to 16 sccm, the flow rate of the oxygen gas is set to 40 sccm to 70 sccm, and the operating temperature is set to 80 °C to 150 °C. In an exemplary embodiment, the flow rate of the argon gas is set to 15 sccm, the flow rate of the oxygen gas is set to 60 sccm, and the operating temperature is set to 120 °C.

In a specific embodiment, a set of longwave pass films is disclosed, as shown in Table 4:

Table 4: Preset stacked structure of a set of longwave pass films (unit of thickness: nm)

| Material | Nb$_2$O$_5$ | SiO$_2$ | Si:H | SiO$_2$ | Si:H | SiO$_2$ |
|---|---|---|---|---|---|---|
| Layer | 1 | 2 | 3 | 4 | 5 | 6 |
| Thickness | 91.91 | 46.65 | 171.57 | 84.57 | 60 | 41.2 |
| Layer | 7 | 8 | 9 | 10 | 11 | 12 |
| Thickness | 71.23 | 77.52 | 56.51 | 82.7 | 20 | 20 |
| Layer | 13 | 14 | 15 | 16 | 17 | 18 |
| Thickness | 20 | 87.39 | 204.08 | 72.16 | 22.45 | 20 |
| Layer | 19 | 20 | 21 | 22 | 23 | 24 |
| Thickness | 20 | 71.46 | 60.69 | 121.32 | 48.2 | 28.68 |
| Layer | 25 | 26 | 27 | 28 | 29 | 30 |
| Thickness | 77.34 | 134.21 | 46.61 | 72.18 | 24.95 | 25.79 |

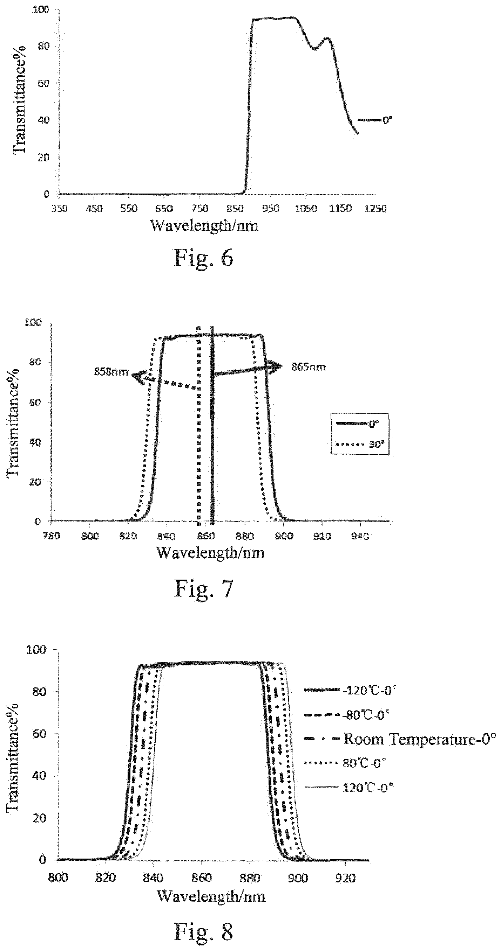

The transmittance curve of the set of secondary films 53 is shown in FIG. 6. In the wavelength range of 350 nm to 1200 nm, the set of secondary films 53 includes a passband and a cut-off band, and the passband of the set of secondary films ranges from about 900 nm to 1000 nm. Exemplarily, a near-infrared bandpass filter includes the set of longwave pass films and the set of narrow bandpass films disclosed in Table 1, and the passband of the set of longwave pass films covers the passband of the set of narrow bandpass films.

In an exemplary embodiment, the set of secondary films 53 is a set of wide bandpass films, and the passband of the set of wide bandpass films covers the passband of the set of narrow bandpass films. The average blocking of set of wide bandpass films is greater than the blocking of the set of narrow bandpass films in a wavelength region smaller than the minimum wavelength of the passband of the set of wide bandpass films.

In an exemplary embodiment, a thickness $d_{f1}$ of the set of main films 52 satisfies: $d_{f1} < 7\mu m$, and a thickness $d_{f2}$ of the set of secondary films satisfies: $d_{f2} < 8\mu m$.

In an exemplary embodiment, a linear expansion coefficient a of the substrate 51 satisfies $3 \times 10^{-6}$ /°C $< \alpha <$ $17 \times 10^{-6}$ /°C , a Poisson's ratio $\mu_s$ of the substrate 51 satisfies $0.2 < \mu_s < 0.32$ , and the refractive index temperature coefficient of the substrate 51 is $\delta_s = (dn_s/dt)/n_s$, where $dn_s/dt$ satisfies $-10*10^{-6}/°C < dn_s/dt < 10*10^{-6}/°C$.

The refractive index $n_1$ of the high refractive index film layer satisfies $3 < n_1$, and the refractive index temperature coefficient of the high refractive index film layer is $\delta_1 = (dn_1/dt)/n_1$, where $dn_1/dt$ satisfies $-15*10^{-6}/°C < dn_1/dt < 15*10^{-6}/°C$. The linear expansion coefficient $\beta_1$ of the high refractive index film layer satisfies $1 \times 10^{-6}$ / °C $< \beta_1 < 15 \times 10^{-6}$ / °C, and the Poisson's ratio $\mu_1$ of the high refractive index film layer satisfies $0.1 < \mu_1 < 0.5$

The linear expansion coefficient $\beta_2$ of the first low refractive index film layer satisfies $\beta_2 < 13 \times 10^{-7}$ /°C, the Poisson's ratio $\mu_2$ of the first low refractive index film layer satisfies $0.1 < \mu_2 < 0.5$, and the refractive index temperature coefficient of the first low refractive index film layer is $\delta_2 = (dn_2/dt/n_2$, where $dn_2/dt$ satisfies $-5*10^{-6}/°C < dn_2/dt < 5*10^{-6}/°C$.

With such arrangement, the linear expansion coefficient $\beta$ of the set of main films 52 is $\beta = z_1\beta_1 + z_2\beta_2$, where $0 < z1 < 1$, and $0 < z2 < 1$. Z1 is a weight coefficient of the high refractive index film layer, and z2 is a weight coefficient of the first low refractive index film layer. Exemplarily, z1 is equal to the ratio of a sum of the thicknesses of all the high refractive index film layers to the thickness of the set of main films 52, and $z_1 + z_2 = 1$.

$\delta$ is an equivalent phase that satisfies the relationship of $\delta = (v\delta_1 + (1-v)\delta_2$, and $\mu$ is an equivalent Poisson ratio that satisfies the relationship of $\mu = (v\mu_1 + (1-v)\mu_2)$.

$$n = n_1 \left[ \frac{m - (m-1)(n_2 / n_1)}{(m-1) - (m-1)(n_2 / n_1) + (n_1 / n_2)} \right]^{1/2}$$

An equivalent refractive index n of the set of main films 52 is

, where m is an interference order of the filter, and $0 < m$. Since n2 < nl, $0 < n < n1$ is known. Specifically, $1 < m < 15$.

An aggregation density $P_o$ of the film layer of the set of main films 52 satisfies $0.9 < P_0 < 1.6$.

A center wavelength $\lambda_c$ of the passband of the near-infrared bandpass filter provided in an example of the present disclosure varies with the change of the temperature T. The temperature drift $\Delta\lambda_c / \Delta T$ of $\lambda_c$ satisfies:

$$\Delta\lambda_c / \Delta T = \Delta(n_T d_T) \times \lambda / (n_c d_c \Delta T)$$
$$= \lambda \left[ \{ P_0 (n_T + n_T\delta) (1+3\beta) / (1+3\beta + A) + 1 - P_0 (1+3\beta) / (1+3\beta + A) \} \{ d_0 (1 - B + \beta) \} / n_c d_c - 1 \right]'$$

Where, $A = 2(\alpha - \beta)(1 - 3\mu) /(1- \mu)$, $B = 2\mu(\alpha - \beta) / (1- \mu)$, $n_c$ is an equivalent refractive index of the set of main films 52 at an initial temperature $T_0$, and $d_c$ is a physical thickness of the set of main films 52 at the initial temperature $T_0$. $n_T$ is an equivalent refractive index of the set of main films 52 at a to-be-measured temperature $T_t$, and $d_T$ is a physical thickness of the set of main films 52 at the to-be-measured temperature $T_t$.

It can be calculated that $\Delta\lambda_c / \Delta T$ satisfies $\Delta\lambda_c / \Delta T < 0.15 nm/°C$.

In a specific embodiment, a near-infrared bandpass filter 5 in which a material of a substrate 51 of the near-infrared bandpass filter 5 is glass is disclosed. More specifically, Schott's D263T can be used, the substrate 51 of which has a linear expansion coefficient $\alpha$ of $7.2 \times 10^{-6}/°C$, and a Poisson's ratio $\mu_s$ of 0.208 within the range of -30 °C to 70 °C. The set of main films 52 of the near-infrared bandpass filter 5 is shown in Table 5:

Table 5: Preset stacked structure of a set of main films (unit of thickness: nm)

| Material | SiO$_2$ | Si:H | SiO$_2$ | Si:H | SiO$_2$ | Si:H |
|---|---|---|---|---|---|---|
| Layer | 1 | 2 | 3 | 4 | 5 | 6 |
| Thickness | 191.8 | 98.13 | 58.15 | 133.6 | 138.21 | 199.3 |
| Layer | 7 | 8 | 9 | 10 | 11 | 12 |
| Thickness | 122.2 | 136.73 | 20 | 112.1 | 120.76 | 75.89 |
| Layer | 13 | 14 | 15 | 16 | 17 | 18 |
| Thickness | 114 | 129.46 | 20 | 123.4 | 113.63 | 76.36 |

(continued)

| Material | SiO$_2$ | Si:H | SiO$_2$ | Si:H | SiO$_2$ | Si:H |
|---|---|---|---|---|---|---|
| Layer | 19 | 20 | 21 | 22 | 23 | 24 |
| Thickness | 121.5 | 116.03 | 20 | 134.3 | 117.93 | 83.82 |
| Layer | 25 | 26 | 27 | | | |
| Thickness | 78.45 | 255.61 | 315.2 | | | |

The first layer in the set of main films 52 is the film layer closest to the substrate 51, and the other film layers are stacked along a stacking direction. The odd-numbered layers are first low refractive index film layers having a refractive index of less than 3 and a Poisson's ratio $\mu_2$ of 0.17. The even-numbered layers are high refractive index film layers, and the Poisson's ratio $\mu_1$ is 0.28. The film layers of the set of main films 52 are sputtering reaction coating layers, an aggregation density $P_0$ of the film layer is 1.01, and a linear expansion coefficient $\beta$ is $3 \times 10^{-6}$/°C.

A set of secondary films 53 of the near-infrared bandpass filter 5 is shown in Table 6:

Table 6: Preset stacked structure of a set of secondary films (unit of thickness: nm)

| Material | SiO$_2$ | TiO$_2$ | SiO$_2$ | TiO$_2$ | SiO$_2$ | TiO$_2$ |
|---|---|---|---|---|---|---|
| Layer | 1 | 2 | 3 | 4 | 5 | 6 |
| Thickness | 134.4 | 72.6 | 90.3 | 67.45 | 120.98 | 77.1 |
| Layer | 7 | 8 | 9 | 10 | 11 | 12 |
| Thickness | 136 | 83.4 | 97.5 | 70.9 | 270.45 | 75.64 |
| Layer | 13 | 14 | 15 | 16 | 17 | 18 |
| Thickness | 111.7 | 67.6 | 101.7 | 197.77 | 116.51 | 74.86 |
| Layer | 19 | 20 | 21 | 22 | 23 | 24 |
| Thickness | 118.7 | 75.8 | 120.1 | 76.6 | 103.28 | 42.14 |
| Layer | 25 | 26 | 27 | 28 | 29 | 30 |
| Thickness | 133.6 | 83.1 | 131.4 | 83.54 | 133.68 | 85.88 |
| Layer | 31 | 32 | 33 | 34 | 35 | 36 |
| Thickness | 133.1 | 84.1 | 135.3 | 84.91 | 135.75 | 84.61 |
| Layer | 37 | 38 | 39 | 40 | 41 | 42 |
| Thickness | 87.1 | 75.6 | 124.5 | 80.29 | 129.71 | 82.58 |
| Layer | 43 | 44 | 45 | 46 | 47 | |
| Thickness | 136.4 | 87.5 | 130.1 | 77.82 | 103.24 | |

The film layers of the set of secondary films 53 are sputtering reaction film layers, the material of the second low refractive index film layer is silicon dioxide, and the material of the third low refractive index film layer is titanium dioxide.

The transmittance curves of the near-infrared bandpass filter 5 is shown in FIGS. 7 and 8. FIG. 7 shows that, when the light is incident at an angle of 0 degrees, the near-infrared bandpass filter 5 has a center wavelength of the passband of 865 nm, and, when light is incident at an angle of 30 degrees, the near-infrared bandpass filter 5 has a center wavelength of the passband of 858 nm. FIG. 8 shows the transmittance curves of the near-infrared bandpass filter 5 at multiple operating temperatures with 0°C as the reference temperature. The drift amount of the passband is $\Delta\lambda_c / \Delta T = 0.055 nm$ /°C.

In a specific embodiment, a near-infrared bandpass filter 5 in which a material of a substrate 51 of the near-infrared bandpass filter 5 is glass is disclosed. More specifically, H-ZPK5 of CDGM GLASS CO., LTD can be used, the substrate 51 of which has a linear expansion coefficient $\alpha$ of $12.4 \times 10^{-6}$/°C within the range of -30 °C to 70 °C, and has a linear expansion coefficient $\alpha$ of $14.5 \times 10^{-6}$/°C, and a Poisson's ratio $\mu_s$ of 0.3 within the range of 100 °C to 300 °C. The set of main films 52 of the near-infrared bandpass filter 5 is shown in Table 7:

Table 7: Preset stacked structure of a set of main films (unit of thickness: nm)

| Material | Si:H | $SiO_2$ | $Si_3N_4$ | $SiO_2$ |
|---|---|---|---|---|
| Layer | 1 | 2 | 3 | 4 |
| Thickness | 112.02 | 643.34 | 35.66 | 137.48 |
| Layer | 5 | 6 | 7 | 8 |
| Thickness | 378.9 | 254.07 | 69.13 | 117.18 |
| Layer | 9 | 10 | 11 | 12 |
| Thickness | 525.28 | 111.77 | 99.29 | 102.46 |
| Layer | 13 | 14 | 15 | 16 |
| Thickness | 531.19 | 69.91 | 100.9 | 117.21 |
| Layer | 17 | 18 | 19 | 20 |
| Thickness | 535.44 | 31.18 | 112.69 | 48.18 |
| Layer | 21 | 22 | 23 | 24 |
| Thickness | 372.35 | 140.21 | 139.71 | 28 |
| Layer | 25 | 26 | | |
| Thickness | 109.1 | 29.22 | | |

The film layers of the set of main films 52 are sputtered reactive coating layers, and the first layer is closest to the substrate 51. The material of the high refractive index film layer of the set of main films 52 is Si:H and the Poisson's ratio $\mu_1$ is 0.28. The material of the first low refractive index film layer is $SiO_2$, the material of the fourth low refractive index film layer is $Si_3N_4$, and the Poisson's ratio $\mu_2$ is 0.17. The set of main films 52 has a structure of $H\text{-}(L_1\text{-}L_4\text{-}L_1\text{-}H)^s\text{-}L_4$, an aggregation density $P_0$ of the film layer is 1.01, and a linear expansion coefficient $\beta$ is $3.5 \times 10^{-6}/°C$.

The set of secondary films 53 of the near-infrared bandpass filter 5 has a preset stacked structure as shown in Table 6, and the film layers of the set of secondary films 53 are evaporative coating layers.

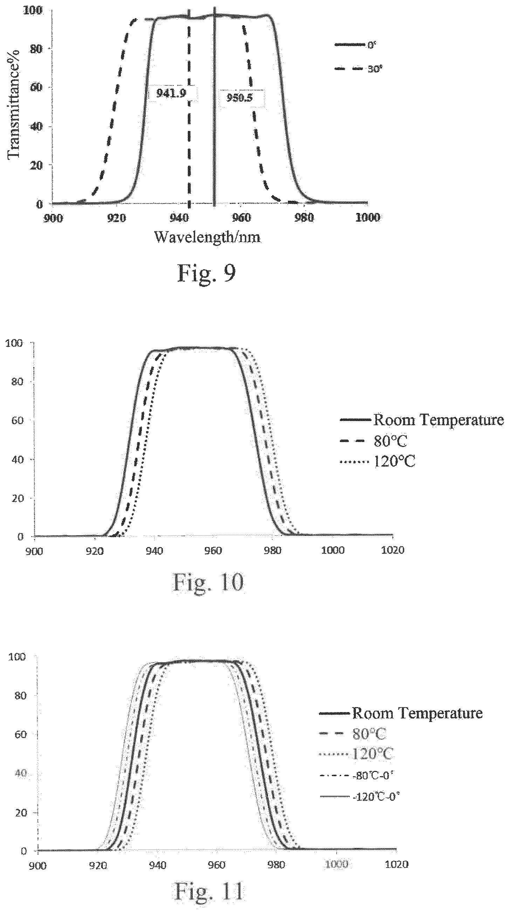

When the crystalline structure of the high refractive index film layer is amorphous, the transmittance curves of the near-infrared bandpass filter 5 are shown in FIGS. 9 and 10. FIG. 9 shows that, when the light is incident at an angle of 0 degrees, the near-infrared bandpass filter 5 has a center wavelength of the passband of 950.5 nm, and, when light is incident at an angle of 30 degrees, the near-infrared bandpass filter 5 has a center wavelength of the passband of 941.9 nm. FIG. 10 shows the transmittance curves of the near-infrared bandpass filter 5 at multiple operating temperatures with 0°C as the reference temperature. The drift amount of the passband is $\Delta\lambda_c / \Delta T < 0.055 nm / °C$. The side (UV side) of the passband close to the short wave has a transmittance of 10% and 90% where the steepness is 6 nm and 10 nm, respectively, and the drift is 8 nm. The side (IR side) of the passband close to the long wave has a transmittance of 10% and 90% where the steepness is 7 nm and 7 nm, respectively, and the drift is 9.5 nm.

Exemplarily, the crystalline structure of a portion of the high refractive index film layer of the near-infrared bandpass filter 5 is in a crystalline state, and specifically may be a single crystal, a polycrystal, or a microcrystal. The volume of this portion constitutes 15% of the volume of the high refractive index film layer. The transmittance curves of the near-infrared bandpass filter 5 are shown in FIG. 11. FIG. 11 shows the transmittance curves of the near-infrared bandpass filter 5 at multiple operating temperatures with 0°C as the reference temperature. The drift amount of the passband is $\Delta\lambda_c / \Delta T \le 0.03 nm/°C$ (about 0.025 nm/°C). It can be seen that the drift amount of the passband is much small when the volume of the crystal structure in the high refractive index film accounts for 15%.

In a particular embodiment, a near-infrared bandpass filter 5 is disclosed, and the material of the substrate 51 of the near-infrared bandpass filter 5 is glass. Specifically, H-ZPK7 of CDGM GLASS CO., LTD can be used, the substrate 51 of which has a linear expansion coefficient $\alpha$ of $13.4 \times 10^{-6}/°C$ within the range of -30 °C to 70 °C, and has a linear expansion coefficient $\alpha$ of $15.9 \times 10^{-6}/°C$, and a Poisson's ratio $\mu_s$ of 0.306 within the range of 100°C to 300 °C. A set of main films 52 of the near-infrared bandpass filter 5 is shown in Table 8:

Table 8: Preset stacked structure of a set of main films (unit of thickness: nm)

| Material | SiO$_2$ | Ge:H | SiO$_2$ | Ge:H | SiO$_2$ | Ge:H |
|---|---|---|---|---|---|---|
| Layer | 1 | 2 | 3 | 4 | 5 | 6 |
| Thickness | 204.1 | 73.1 | 193 | 379.6 | 115 | 196.3 |
| Layer | 7 | 8 | 9 | 10 | 11 | 12 |
| Thickness | 111.7 | 202.6 | 86 | 119 | 107 | 64.44 |
| Layer | 13 | 14 | 15 | 16 | 17 | 18 |
| Thickness | 112.6 | 65 | 107.6 | 128 | 64.3 | 87.5 |
| Layer | 19 | 20 | 21 | 22 | 23 | 24 |
| Thickness | 111.4 | 103 | 112 | 152 | 63.5 | 278 |
| Layer | 25 | 26 | 27 | 28 | 29 | 30 |
| Thickness | 109.9 | 66.2 | 106.4 | 269 | 140 | 278.8 |
| Layer | 31 | 32 | 33 | 34 | 35 | |
| Thickness | 110.3 | 226.9 | 190.6 | 105.2 | 35.38 | |

The film layers of the set of main films 52 are sputtered reactive coating layers, and the first layer is closest to the substrate 51. The material of the high refractive index film layer of the set of main films 52 is Ge:H, and the Poisson's ratio $\mu_1$ is 0.22. The material of the second low refractive index film layer is SiO$_2$, and the Poisson's ratio $\mu_2$ is 0.17. The set of main films 52 has an aggregation density P$_0$ of the film layer of 1.08 and a linear expansion coefficient $\beta$ of 2.7×10$^{-6}$/°C.

A set of secondary films 53 of the near-infrared bandpass filter 5 is shown in Table 9:

Table 9: Preset stacked structure of a set of secondary films (unit of thickness: nm)

| Material | SiO$_2$ | TiO$_2$ | SiO$_2$ | TiO$_2$ | SiO$_2$ | TiO$_2$ |
|---|---|---|---|---|---|---|
| Layer | 1 | 2 | 3 | 4 | 5 | 6 |
| Thickness | 134.4 | 72.6 | 90.3 | 67.45 | 120.98 | 77.91 |
| Layer | 7 | 8 | 9 | 10 | 11 | 12 |
| Thickness | 136 | 83.4 | 97.5 | 70.9 | 270.45 | 75.64 |
| Layer | 13 | 14 | 15 | 16 | 17 | 18 |
| Thickness | 111.7 | 67.6 | 101.7 | 197.77 | 116.51 | 74.86 |
| Layer | 19 | 20 | 21 | 22 | 23 | 24 |
| Thickness | 118.7 | 75.8 | 120.1 | 76.06 | 103.28 | 42.14 |
| Layer | 25 | 26 | 27 | 28 | 29 | 30 |
| Thickness | 133.6 | 83.1 | 131.4 | 83.54 | 133.68 | 85.88 |
| Layer | 31 | 32 | 33 | 34 | 35 | 36 |
| Thickness | 133.1 | 84.1 | 135.3 | 84.91 | 135.75 | 84.61 |
| Layer | 37 | 38 | 39 | 40 | 41 | 42 |
| Thickness | 87.1 | 75.6 | 124.5 | 80.29 | 129.71 | 82.58 |
| Layer | 43 | 44 | 45 | 46 | 47 | |
| Thickness | 136.4 | 87.5 | 130.1 | 77.82 | 103.24 | |

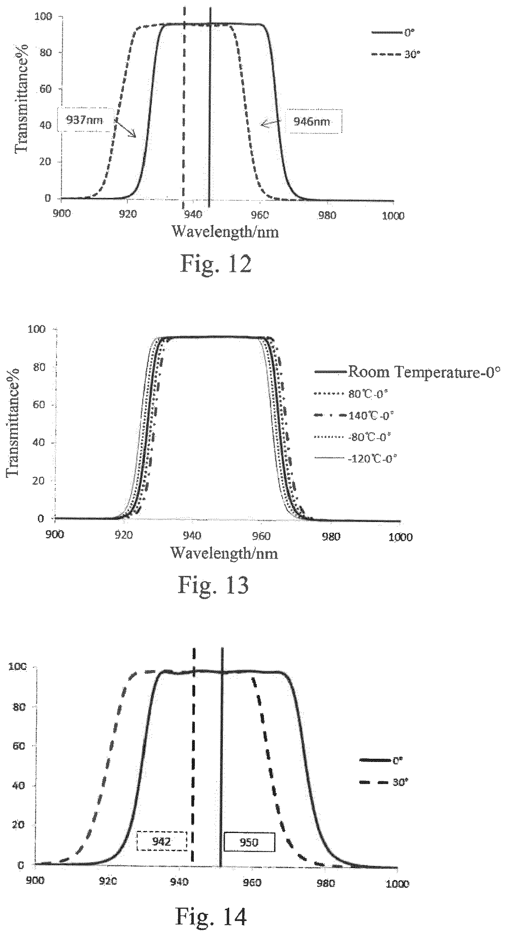

The film layers of the set of secondary films 53 are evaporative coating layers.
The transmittance curves of the near-infrared bandpass filter 5 are shown in FIGS. 12 and 13. FIG. 12 shows that, when the light is incident at an angle of 0 degrees, the near-infrared bandpass filter 5 has a center wavelength of the passband of 946 nm, and, when light is incident at an angle of 30 degrees, the near-infrared bandpass filter 5 has a center wavelength of the passband of 937 nm. FIG. 10 shows the transmittance curves of the near-infrared bandpass filter 5 at multiple operating temperatures with 0°C as the reference temperature. The drift amount of the passband is $\Delta\lambda_c / \Delta T < 0.015 nm/°C$.

In a particular embodiment, a near-infrared bandpass filter 5 is disclosed, and the material of the substrate 51 of the near-infrared bandpass filter 5 is glass. Specifically, H-ZPK7 of CDGM GLASS CO., LTD can be used, the substrate 51 of which has a linear expansion coefficient $\alpha$ of $13.4 \times 10^{-6}/°C$ within the range of -30 °C to 70 °C, and has a linear expansion coefficient $\alpha$ of $15.9 \times 10^{-6}/°C$, and a Poisson's ratio $\mu_s$ of 0.306 within the range of 100 °C to 300 °C. A set of main films 52 of the near-infrared bandpass filter 5 is shown in Table 10:

Table 10: Preset stacked structure of a set of main films (unit of thickness: nm)

| Material | $SiO_2$ | $Si_xGe_{1-x}$ | $SiO_2$ | $Si_xGe_{1-x}$ | $SiO_2$ | $Si_xGe_{1-x}$ |
|---|---|---|---|---|---|---|
| Layer | 1 | 2 | 3 | 4 | 5 | 6 |
| Thickness | 230.8 | 112 | 101 | 285.9 | 105.7 | 99.5 |
| Layer | 7 | 8 | 9 | 10 | 11 | 12 |
| Thickness | 66 | 236 | 102.8 | 100.9 | 76.7 | 433.5 |
| Layer | 13 | 14 | 15 | 16 | 17 | 18 |
| Thickness | 96.5 | 99.3 | 96 | 434.3 | 68.9 | 109.3 |
| Layer | 19 | 20 | 21 | 22 | 23 | 24 |
| Thickness | 93.7 | 244.3 | 22.8 | 281.39 | 98.79 | 209.72 |
| Layer | 25 | 26 | 27 | 28 | 29 | 30 |
| Thickness | 117.2 | 273.8 | 75.66 | 89.02 | 139.3 | 128.6 |
| Layer | 31 | 32 | 33 | | | |
| Thickness | 218.8 | 113.7 | 83.9 | | | |

The first layer in the set of main films 52 is the film layer closest to the substrate 51. The odd-numbered layers are first low refractive index film layers, and the Poisson's ratio $\mu_2$ is 0.17. The even-numbered layers are high refractive index film layers, and the Poisson's ratio $\mu_1$ is 0.26. The film layers of the set of main films 52 are sputtering reaction coating layers. An aggregation density $P_0$ of the film layer is 1.02, and a linear expansion coefficient $\beta$ is $2 \times 10^{-6}/°C$.

A set of secondary films 53 of the near-infrared bandpass filter 5 is shown in Table 11:

Table 11: Preset stacked structure of a set of secondary films (unit of thickness: nm)

| Material | $SiO_2$ | $Si_xGe_{1-x}$ | $SiO_2$ | $Si_xGe_{1-x}$ | $SiO_2$ | $Si_xGe_{1-x}$ |
|---|---|---|---|---|---|---|
| Layer | 1 | 2 | 3 | 4 | 5 | 6 |
| Thickness | 72 | 134.4 | 109.2 | 26 | 45.1 | 138.13 |
| Layer | 7 | 8 | 9 | 10 | 11 | 12 |
| Thickness | 67 | 230 | 92 | 29 | 32.9 | 159 |
| Layer | 13 | 14 | 15 | 16 | 17 | 18 |
| Thickness | 112.9 | 136.65 | 94.1 | 219 | 41 | 132 |
| Layer | 19 | 20 | 21 | 22 | 23 | 24 |
| Thickness | 55.8 | 54 | 119 | 65 | 64.5 | 59.3 |
| Layer | 25 | 26 | 27 | 28 | 29 | |
| Thickness | 139.6 | 44.68 | 89 | 137.07 | 262.25 | |

The film layers of the set of secondary films 53 are sputtering reaction coating layer, the odd-numbered layers are second low refractive index film layers, and the even-numbered layers are high refractive index film layers.

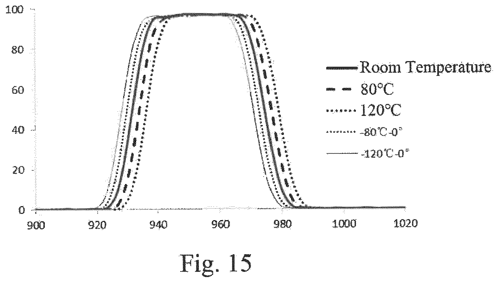

The transmittance curves of the near-infrared bandpass filter 5 are shown in FIGS. 14 and 15. FIG. 14 shows that, when the light is incident at an angle of 0 degrees, the near-infrared bandpass filter 5 has a center wavelength of the passband of 950 nm, and, when light is incident at an angle of 30 degrees, the near-infrared bandpass filter 5 has a center wavelength of the passband of 942 nm. FIG. 15 shows the transmittance curves of the near-infrared bandpass filter 5 at multiple operating temperatures with 0°C as the reference temperature. The drift amount of the passband is $\Delta\lambda_c / \Delta T < 0.015 nm/°C$.

FIG. 2 shows a schematic diagram of an operating state of an optical sensing system according to an example of the present disclosure. Referring to FIGS. 1 and 2, the optical sensing system includes a near-infrared bandpass filter 5 and an image sensor 6. A first lens assembly 4 is further provided at an object side of the near-infrared bandpass filter 5. The light emitted or reflected by a to-be-detected target 1 passes through the first lens assembly 4 and then reaches the near-infrared bandpass filter 5. The filtered light formed by the light passing through the near-infrared bandpass filter 5 reaches the image sensor 6. The filtered light triggers the image sensor 6 to form an image signal. The optical sensing system provided with the infrared bandpass filter 5 disclosed in the present disclosure can be applied to at least -150 °C to 300 °C, and the quality of the resulting image is stable.

The optical sensing system may also be an infrared identification system including an infrared light source 2 (Infrared Radiation, IR light source), a second lens assembly 3, a first lens assembly 4, a near infrared bandpass filter 5, and an image sensor 6, wherein the image sensor 6 is a three-dimensional sensor.

The foregoing is only a description of the preferred embodiments of the present disclosure and the applied technical principles. It should be appreciated by those skilled in the art that the protective scope of the present disclosure is not limited to the technical solutions formed by the particular combinations of the above technical features. The protective scope should also cover other technical solutions formed by any combinations of the above technical features or equivalent features thereof without departing from the concept of the technology, such as, technical solutions formed by replacing the features as disclosed in the present disclosure with (but not limited to), technical features with similar functions.

**Claims**

1. A near-infrared bandpass filter, **characterized in that**, the near-infrared bandpass filter comprises a substrate, a set of main films located on a first side of the substrate and a set of secondary films located on a second side of the substrate, the second side is opposite to the first side;

   the set of main films comprises a high refractive index film layer and a first low refractive index film layer arranged in a first preset stacked structure;
   the set of secondary films comprises a second low refractive index film layer and a third low refractive index film layer arranged in a second preset stacked structure, a refractive index of the third low refractive index film layer is different from a refractive index of the second low refractive index film layer, or the set of secondary films comprises the high refractive index film layer and the second low refractive index film layer arranged in a second preset stacked structure;
   in a wavelength range of 780nm to 3000nm, the near-infrared bandpass filter has at least one passband, and when a temperature is changed from -150 °C to 300 °C, a drift amount of a center wavelength of the at least one passband is less than 0.15 nm/°C.

2. The near-infrared bandpass filter according to claim 1, **characterized in that**, when the temperature is changed from -30 °C to 85 °C, the drift amount of the center wavelength of the passband of the near-infrared bandpass filter is less than 0.09 nm/°C.

3. The near-infrared bandpass filter according to claim 1, **characterized in that**, the high refractive index film layer has a refractive index of more than 3 for any wavelength in the wavelength range of 780 nm to 3000 nm.

4. The near-infrared bandpass filter according to claim 3, **characterized in that**, an extinction coefficient of the high refractive index film layer is less than 0.01.

5. The near-infrared bandpass filter according to claim 4, **characterized in that**, the high refractive index film layer has the refractive index of more than 3.6 and the extinction coefficient of less than 0.005 at a wavelength of 850 nm.

6. The near-infrared bandpass filter according to claim 1, **characterized in that**, a thickness $d_{f1}$ of the set of main films

satisfies $d_{f1} < 7\mu m$, and a thickness $d_{f2}$ of the set of secondary films satisfies $d_{f2} < 8\mu m$.

7. The near-infrared bandpass filter according to claim 1, **characterized in that**, a portion of the high refractive index film layer has a crystalline crystal structure and another portion has an amorphous crystal structure; a ratio between a volume of the portion in the crystalline crystal structure and a volume of the high refractive index film layer is within 10% to 20%.

8. The near-infrared bandpass filter according to claim 1, **characterized in that**, a material of the high refractive index film layer comprises a mixture of one or more of silicon hydride, germanium hydride, boron-doped silicon hydride, boron-doped germanium hydride, nitrogen-doped silicon hydride, nitrogen-doped germanium hydride, phosphorous-doped silicon hydride, phosphorous-doped germanium hydride, or $Si_xGe_{1-x}$, where $0<x<1$.

9. The near-infrared bandpass filter according to claim 1, **characterized in that**, a material of the first low refractive index film layer, a material of the second low refractive index film layer and a material of the third low refractive index film layer each comprises a mixture of one or more of $SiO_2$, $Si_3N_4$, $SiO_pN_q$, $Ta_2O_5$, $Nb_2O_5$, $TiO_2$, $Al_2O_3$, SiCN, or SiC, where $q=(4-2p)/3$, and $0<p<1$.

10. The near-infrared bandpass filter according to claim 1, **characterized in that**, in a direction away from the substrate, the first preset stacked structure is in a form of $(L_1\text{-}H)^s\text{-}L1$, or $(H\text{-}L_1)^s$, where H represents the high refractive index film layer, $L_1$ represents the first low refractive index film layer, $s$ represents a number of repetitions of a structure in parentheses, and s is an integer equal to or greater than 1.

11. The near-infrared bandpass filter according to claim 1, **characterized in that**, the set of main films further comprises a fourth low refractive index film layer, and a refractive index of the first low refractive index film layer is not equal to a refractive index of the fourth low refractive index film layer.

12. The near-infrared bandpass filter according to claim 11, **characterized in that**, in a direction away from the substrate, the first preset stacked structure is in a form of: $(L_1\text{-}L_4\text{-}L_1\text{-}H)^s\text{-}L_1$; $(L_1\text{-}L_4\text{-}L_1\text{-}H)^s\text{-}L_4$; $H\text{-}(L_1\text{-}L_4\text{-}L_1\text{-}H)^s\text{-}L_1$; or $H\text{-}(L1\text{-}L_4\text{-}L_1\text{-}H)^s\text{-}L_4$, where H represents the high refractive index film layer, $L_1$ represents the first low refractive index film layer, $L_4$ represents the fourth low refractive index film layer, $s$ represents a number of repetitions of a structure in parentheses, and s is an integer greater than or equal to 1.

13. The near-infrared bandpass filter according to claim 1, **characterized in that**, the set of main films is a set of narrow bandpass films, and the set of secondary films is a set of wide bandpass films or a set of longwave pass films.

14. The near-infrared bandpass filter according to claim 13, **characterized in that**, the set of narrow bandpass films has at least one passband in the wavelength range of 780nm to 3000nm.

15. The near-infrared band pass filter according to claim 14, **characterized in that**, the set of secondary films is the set of longwave pass films; and the set of longwave pass films has at least one passband and one cut-off band in a wavelength range of 350 nm to 3000nm, and the passband of the set of longwave pass films covers the passband of the set of narrow bandpass films.

16. The near-infrared bandpass filter according to claim 14, **characterized in that**, the set of secondary films is the set of wide bandpass films, and a passband of the set of wide bandpass films covers the passband of the set of narrow bandpass films; and an average blocking of the set of wide bandpass films is greater than a blocking of the set of narrow bandpass films in a wavelength region less than a minimum wavelength of the passband of the set of narrow bandpass films.

17. The near-infrared bandpass filter according to claim 1, **characterized in that**, a material of the substrate has a linear expansion coefficient between $3*10^{-6}/°C$ and $17*10^{-6}/°C$.

18. The near-infrared bandpass filter according to claim 1, **characterized in that**, the set of main films and the set of secondary films are formed by a sputtering reaction apparatus or an evaporation apparatus.

19. An optical sensing system, **characterized in that**, the optical sensing system comprises an image sensor and the near-infrared bandpass filter according to any one of claims 1-18, the near-infrared bandpass filter is disposed on a photosensitive side of the image sensor.

52

51

53

Fig. 1

1

3  2

4  5  6

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

Fig. 15

## INTERNATIONAL SEARCH REPORT

| International application No. |
| --- |
| **PCT/CN2019/130575** |

**A. CLASSIFICATION OF SUBJECT MATTER**

G02B 5/20(2006.01)i; G02B 5/28(2006.01)i

According to International Patent Classification (IPC) or to both national classification and IPC

**B. FIELDS SEARCHED**

Minimum documentation searched (classification system followed by classification symbols)

G02B5/-

Documentation searched other than minimum documentation to the extent that such documents are included in the fields searched

Electronic data base consulted during the international search (name of data base and, where practicable, search terms used)

CNPAT, CNKI, EPODOC, WPI, USTXT, WOTXT: 信阳舜宇, 陈策, 丁维红, 陈惠广, 方叶庆, 肖念慈, 红外, 带通, 滤光, 滤波, 基底, 基材, 主膜, 辅膜, 低, 高, 折射, 硅, 锗, 温漂, 漂移, 图像, 传感器, filter, pass, infrared, film, base, plate, refractive, index, Si, Ge, image, sensor

**C. DOCUMENTS CONSIDERED TO BE RELEVANT**

| Category* | Citation of document, with indication, where appropriate, of the relevant passages | Relevant to claim No. |
| --- | --- | --- |
| PX | CN 110109208 A (XINYANG SUNNY OPTICAL CO., LTD.) 09 August 2019 (2019-08-09) claims 1-19, description, paragraphs [0005]-[0140], and figures 1-15 | 1-19 |
| X | CN 108873135 A (XINYANG SUNNY OPTICAL CO., LTD.) 23 November 2018 (2018-11-23) description, paragraphs [0003] and [0036]-[0152], and figures 1-11 | 1-19 |
| X | CN 208596240 U (XINYANG SUNNY OPTICAL CO., LTD.) 12 March 2019 (2019-03-12) description, paragraphs [0003] and [0036]-[0152], and figures 1-11 | 1-19 |
| A | CN 109655954 A (ZHEJIANG CRYSTAL OPTECH CO., LTD.) 19 April 2019 (2019-04-19) entire document | 1-19 |
| A | CN 107841712 A (ZHEJIANG CRYSTAL OPTECH CO., LTD.) 27 March 2018 (2018-03-27) entire document | 1-19 |
| A | CN 108761614 A (XINYANG SUNNY OPTICAL CO., LTD.) 06 November 2018 (2018-11-06) entire document | 1-19 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **18 March 2020** | **27 March 2020** |

| Name and mailing address of the ISA/CN | Authorized officer |
| --- | --- |
| **China National Intellectual Property Administration (ISA/CN)** <br> **No. 6, Xitucheng Road, Jimenqiao Haidian District, Beijing 100088** <br> **China** | |
| Facsimile No. **(86-10)62019451** | Telephone No. |

Form PCT/ISA/210 (second sheet) (January 2015)

## INTERNATIONAL SEARCH REPORT

| | International application No. |
|---|---|
| | **PCT/CN2019/130575** |

**C.    DOCUMENTS CONSIDERED TO BE RELEVANT**

| Category* | Citation of document, with indication, where appropriate, of the relevant passages | Relevant to claim No. |
|---|---|---|
| A | JP 03210503 A (HORIBA LTD.) 13 September 1991 (1991-09-13)<br>    entire document | 1-19 |

Form PCT/ISA/210 (second sheet) (January 2015)

**INTERNATIONAL SEARCH REPORT**
Information on patent family members

International application No.

**PCT/CN2019/130575**

| Patent document cited in search report | | | Publication date (day/month/year) | Patent family member(s) | | | Publication date (day/month/year) |
|---|---|---|---|---|---|---|---|
| CN | 110109208 | A | 09 August 2019 | None | | | |
| CN | 108873135 | A | 23 November 2018 | None | | | |
| CN | 208596240 | U | 12 March 2019 | None | | | |
| CN | 109655954 | A | 19 April 2019 | None | | | |
| CN | 107841712 | A | 27 March 2018 | US | 2019352222 | A1 | 21 November 2019 |
| | | | | CN | 107841712 | B | 30 October 2018 |
| | | | | WO | 2019085265 | A1 | 09 May 2019 |
| | | | | TW | 201923126 | A | 16 June 2019 |
| | | | | KR | 20190060799 | A | 03 June 2019 |
| CN | 108761614 | A | 06 November 2018 | None | | | |
| JP | 03210503 | A | 13 September 1991 | JP | 2724563 | B2 | 09 March 1998 |
| | | | | JP | H03210503 | A | 13 September 1991 |

Form PCT/ISA/210 (patent family annex) (January 2015)

**EP 3 982 169 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201910486854